# EUROPÄISCHE PATENTSCHRIFT

(11) **EP 3 473 455 B1**
(45) Veröffentlichungstag und Bekanntmachung des Hinweises auf die Patenterteilung: **13.05.2020**
(21) Anmeldenummer: 18184331.9
(22) Anmeldetag: 19.07.2018
(51) Int. Cl.: B60C 23/04, G06K 19/077, H01Q 1/22, H05K 3/02, H01Q 9/20

(54) **VERFAHREN ZUR HERSTELLUNG EINES TRANSPONDERS FÜR EINEN FAHRZEUGREIFEN**
METHOD FOR MANUFACTURING A TRANSPONDER FOR A VEHICLE TYRE
PROCÉDÉ DE FABRICATION D'UN TRANSPONDEUR POUR UN PNEUMATIQUE DE VÉHICULE

(30) Priorität: 20.10.2017 DE 102017218760
(43) Veröffentlichungstag der Anmeldung: 24.04.2019
(73) Patentinhaber: Continental Reifen Deutschland GmbH, 30165 Hannover (DE)
(72) Erfinder: Ehmke, Tobias, 30826 Garbsen (DE); Kurz, Martin, 30161 Hannover (DE)
(74) Vertreter: Widjaja, Wira

(56) Entgegenhaltungen:
- US-A1- 2009 081 424
- US-A1- 2011 000 969

## Beschreibung

Die Erfindung betrifft ein Verfahren zur Herstellung eines Transponders für einen Fahrzeugreifen.

Es ist bekannt, Fahrzeugreifen mit Transpondern zu versehen.
Aus dem Stand der Technik sind unterschiedliche Konzepte bekannt, Transponder am Reifen anzuordnen. Alle herkömmlichen Konzepte besitzen unterschiedliche Nachteile. Die US 2009/081424A1 offenbart ein Verfahren zum Beschichten von Oberflächen mit einem Substratmaterial.
Die US 2011/000969A1 offenbart ein Verfahren zum Herstellen eines Fahrzeugreifens mit einem Transponder.

Der Erfindung liegt die Aufgabe zugrunde, das Anordnen von Transpondern an Fahrzeugreifen zu verbessern.

Gelöst wird die Aufgabe gemäß eines Verfahrens nach Anspruch 1.

Ein Vorteil der Erfindung ist insbesondere darin zu sehen, dass auf diese Weise Transponder im Fahrzeugreifen auf einfache Weise angeordnet werden können.
Mit dem neuen Verfahren lassen sich die Antennen zu den Transpondern einfach und mit einer hohen Genauigkeit auf eine Gummilage aufbringen. Bei der Gummilage kann es sich beispielsweise um ein Reifenbauteil handeln, welches als eine Materiallage für den Reifenwulst vorgesehen ist. Das Aufbringen der mindestens einer Transponderantenne erfolgt im Rahmen der Herstellung des Vormaterials, welches später bei der Reifenherstellung beispielsweise mit einer Reifenbautrommel appliziert wird. Dadurch wird die Zykluszeit an den Reifenbaumaschinen nicht beeinträchtigt.

In einer vorteilhaften Weiterbildung der Erfindung ist vorgesehen, dass nach Schritt e) ein Transponder-Chip auf der Antenne platziert wird,
wobei durch eine direkte Kontaktierung zwischen beiden Bauteilen ein Transponder mit einer angebunden Antenne gebildet wird.
Dadurch lassen sich der Transponderchip und die Antenne fest miteinander verbinden.

Es ist vorgesehen, dass bei Schritt c) die Substrat-Materiallage ein Reifenbauteil ist.
Als Reifenbauteil kommen unterschiedliche Materiallagen in Frage. Der Transponder mit der Antenne kann beispielsweise auf eine Materiallage für den Reifenwulst aufgebracht werden.

In einer weiteren vorteilhaften Weiterbildung der Erfindung ist vorgesehen, dass die Schritte a) bis d) in den Herstellungsprozeß zur Herstellung des Reifenbauteiles in Form von Vormaterial integriert sind.
Dadurch wird die Zykluszeit an den Reifenbaumaschinen nicht beeinträchtigt.

In einer weiteren vorteilhaften Weiterbildung der Erfindung ist vorgesehen, dass bei Schritt d) das Abtragen von Dünnschichtmaterial mit einem gerichteten Ionenstrahl oder einen hart fokussierten Laserstrahl erfolgt.
it diesem Abtragungsverfahren lässt sich das Dünnschichtmaterial einfach und mit einer hohen Präzision in bestimmten Teilbereichen abtragen.

In einer weiteren vorteilhaften Weiterbildung der Erfindung ist vorgesehen, dass bei Schritt d) das Abtragen von Dünnschichtmaterial mit einer Ätztechnik erfolgt,
wobei Fotolack auf die Dünnschicht aufgebracht und strukturiert beleuchtet wird. Die Löslichkeit des Lacks nimmt in beleuchteten Regionen ab. Mit einer Ätzlösung kann anschließend die nicht beleuchtete Dünnschicht mit einer hohen Löslichkeit abgetragen werden.

Mit diesem Abtragungsverfahren lässt sich das Dünnschichtmaterial mit einer hohen Geschwindigkeit und einer hohen Präzision in Teilbereichen von der Substrat-Materiallage abtragen.

In einer weiteren vorteilhaften Weiterbildung der Erfindung ist vorgesehen, dass bei Schritt d) eine Lift-Off-Technik eingesetzt wird,wobei zunächst Fotolack auf die Substrat-Materiallage aufgebracht und strukturiert wird. Das anschließend aufgebrachte Dünnschichtmaterial kann dann in einem chemischen Verfahren an den Stellen abgetragen werden, an denen noch Fotolack vorliegt. Es erfolgt damit ein Abtrag von Fotolack und dem sich darauf befindenden Dünnschichtmaterial.
Mit diesen Abtragungsverfahren, bei dem Fotolack eingesetzt wird, lässt sich das Dünnschichtmaterial mit einer hohen Präzision von der Substratmateriallage entfernen.

In einer weiteren vorteilhaften Weiterbildung der Erfindung ist vorgesehen, dass bei Schritt c) eine Dünnschicht mit einer Materialdicke von kleiner 1 mm erzeugt wird.
Dadurch besitzt die Antenne für den Transponder nur eine sehr geringe Materialdicke. Die geringe Materialdicke hat den Vorteil, dass die Dauerhaltbarkeit der Reifenbaumateriallage nicht beeinträchtigt wird.

In einer weiteren vorteilhaften Weiterbildung der Erfindung ist vorgesehen, dass bei Schritt a) der Festkörper ein Metall ist.

Als Festkörpermaterial kann beispielsweise Kupfer eingesetzt werden, welches sich besonders gut als Antennenmaterial einsetzen lässt.

In einer weiteren vorteilhaften Weiterbildung der Erfindung ist vorgesehen, dass der Transponder im Bereich des Reifenwulstes angeordnet ist.
Der Reifenwulst eignet sich besonders für die Platzierung von Transpondern, weil die Dauerbelastung in diesem Bereich des Fahrzeugreifens relativ gering ist. Der Transponder kann jedoch auch in der Seitenwand oder im Bereich des Laufstreifens angeordnet sein.

In einer vorteilhaften Weiterbildung der Erfindung ist vorgesehen, dass die Höhenabmessung in radialer Richtung des Fahrzeugreifens zwischen dem Transponder und der oberen Spitze des Kernreiters mindestens 5 mm beträgt.
Dadurch ist der Transponder in einem Bereich des Reifenwulstes angeordnet in dem die mechanische Beanspruchung im Fahrbetrieb des Fahrzeugreifens relativ gering ist.

In einer weiteren vorteilhaften Weiterbildung der Erfindung ist vorgesehen, dass der Transponder auf der zur Seitenwand gerichteten Außenseite des Kernreiters angeordnet ist. Dadurch läßt sich von außen eine einfache Funkverbindung mit einer hohen Signalqualität zum Transponder realisieren.

In einer vorteilhaften Weiterbildung der Erfindung ist vorgesehen, dass der Transponder mit seinen beiden Antennenteilen in Umfangsrichtung zum Reifenkern ausgerichtet ist. Dadurch besitzt der Transponder eine optimale Ausrichtung im Reifenwulst, um eine optimale Sende- und Empfangsleistung zu gewährleisten.

In einer weiteren vorteilhaften Weiterbildung der Erfindung ist vorgesehen, dass der Transponder eine Breite zwischen 3 und 15 mm sowie eine Länge zwischen 30 und 80 mm aufweist.
Bei diesen Abmessungen des Transponders lässt sich dieser auf einfache Weise zwischen den Reifenbauteilen anordnen.

In einer weiteren vorteilhaften Weiterbildung der Erfindung ist vorgesehen, dass der Transponder im Rahmen der Vorkonfektionierung der Reifenbauteilgruppe aus Reifenkern und Kernreiter aufgebracht wird.
Der Transponder lässt sich im Rahmen der Vorkonfektionierung dieser Reifenbauteilgruppe einfach auf der Außenseite des Kernreiters platzieren.

Anhand mehrerer Ausführungsbeispiele soll die Erfindung näher erläutert werden. Es zeigen:
Fig. 1: einen Reifenwulst
Fig. 2: Schematische Darstellung des Zerstäubungsverfahrens
Fig. 3: eine Aufsicht auf den Transponder mit mäanderförmigen Antennen

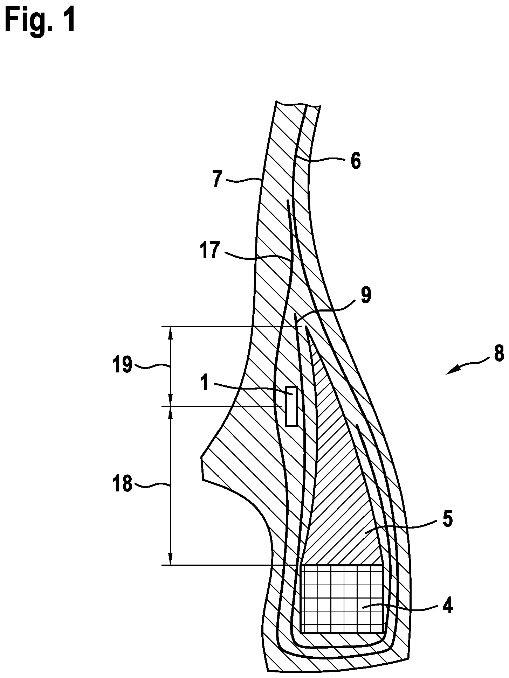

Die Figur 1 zeigt schematisch den Querschnitt eines Reifenwulstes 8. Bei diesem Ausführungsbeispiel ist der Transponder 1 im Reifenwulst 8 angeordnet. Der Transponder kann auch an anderen Stellen im Fahrzeugreifen angeordnet sein. Weitere bevorzugte Positionen für Transponder sind Bereiche der Seitenwand, Bereiche des Laufstreifens oder aber Bereiche in der Gürtellage des Fahrzeugreifens. Der Transponder 1 ist im Reifenwulst z. B. zwischen dem Kernreiter 5 und dem äußeren Lagenumschlag 17 der Karkasslage 6 angeordnet. Die Karkasslage 6 bildet im Reifenwulst 8 einen Lagenumschlag 17, der um den Kernreiter 5 und den Reifenkern 4 herumgeführt ist. Der Reifenkern 4 umfasst eine Vielzahl von Drahtkernen und hat daher eine sehr hohe Materialsteifigkeit. Durch diese Materialsteifigkeit des Reifenkerns ist der Transponder in einer besonders beruhigten Materialzone des Fahrzeugreifens angeordnet, die nur geringen Materialbelastungen ausgesetzt ist.
Um den Kernreiter 5 und den Reifernkern 4 ist optional eine zusätzliche Gummilage 9 angeordnet, die ebenfalls als "Flipper-Bauteil" bezeichnet wird.
Bei dieser zweiten Ausführung ist der Transponder 1 zwischen der Gummilage 9 und dem Lagenumschlag 9 angeordnet.
Die Höhe 18 zwischen Transponder 1 und Unterseite des Kernreiters 5 beträgt mindestens 3 mm, vorzugsweise mindestens 5 mm oder mindestens 7 mm. Durch die höhere

Positionierung des Transponders 1 läßt sich die Signalübertragung zum Empfangsgerät besser realisieren.
Außerdem beträgt die Höhe 19 zwischen Transponder 1 und der Spitze des Kernreiters 5 mindestens 5 mm, vorzugsweise mindestens 7 mm oder mindestens 9 mm.
Die Daten des Transponders lassen sich dadurch sehr gut mit einem externen Lesegerät auslesen.

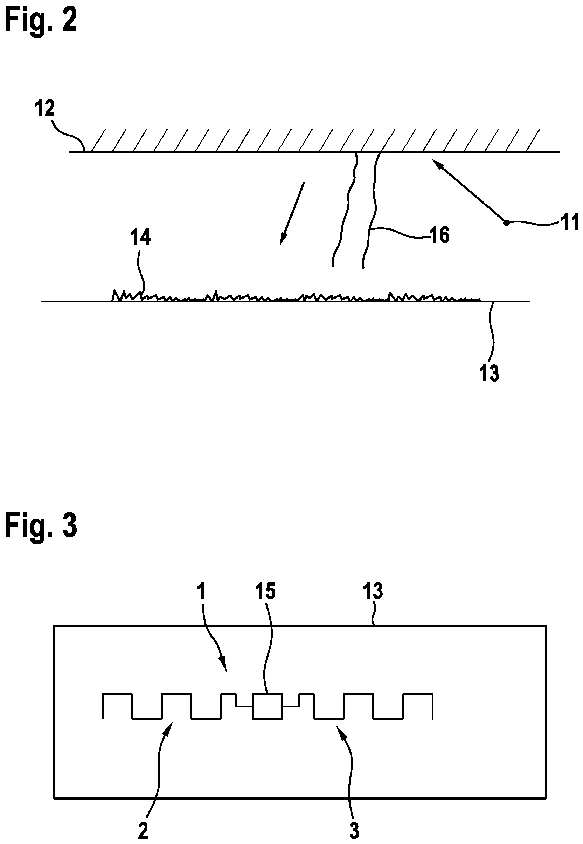

Die Figur 2 zeigt schematisch das Aufbringen des Dünnschichtmaterials 14 auf die Substratmateriallage 13, die aus einem Elastomer besteht und vorzugsweise ein Reifenbauteil ist. Bei dem Reifenbauteil könnte es sich z.B. um ein Reifenbauteil für den Reifenwulst oder um eine Karkasslage handeln. Das Target-Material 12, welches aus einem Festkörper besteht, wird mit Ionen 11 beschossen. Bei dem Targetmaterial 12 handelt es sich um ein Metall, beispielsweise um Kupfer. Durch den Beschuss mit Ionen 11 wird Festkörpermaterial 16 in Form von Atomen herausgelöst, die anschließend in eine Gasphase übergehen. Die Gasphase mit den Atomen lagert sich anschließend auf der Substratmateriallage bzw. dem Reifenbauteil 13 ab. Auf diese Weise wird eine Dünnschichtmateriallage 14 auf dem Reifenbauteil erzeugt. Anschließend erfolgen die Schritte d) und e) nach Anspruch 1. Bei diesen Verfahrensschritten erfolgt das Abtragen von Teilbereichen der Dünnschicht von dem Reifenbauteil 13 mit einem Abtragungsverfahren. Bei diesem Abtragungsverfahren wird eine Antenne für einen Transponder auf dem Reifenbauteil erzeugt. Die Antennenform der Antenne wird mit der verbleibenden Dünnschicht auf dem Reifenbauteil 13 gebildet. Das Abtragungsverfahren kann beispielsweise mit einem gerichteten Ionenstrahl oder einem hart fokussierten Laserstrahl erfolgen.

Die Fig. 3 zeigt den Transponder 1 mit den beiden Antennenteilen 2 und 3 auf einem Reifenbauteil in der Aufsicht. Die beiden Antennenteile 2 und 3 bilden eine Antenne und bestehen aus dem Festkörpermaterial und wurden mit dem Verfahren nach Anspruch 1 auf die Substratmateriallage bzw. auf das Reifenbauteil 13 aufgebracht.
Bei der Antenne handelt es sich um eine Dipolantenne mit zwei Antennenteilen 2 und 3 (linke und rechte Antenne 2 und 3).

Nach dem Strukturieren der beiden Antennenteile 2 und 3 erfolgt das Platzieren des Transponderchips 15 auf die linke und rechte Antenne 2 und 3. Bei diesem Aufbringen des Transponderchips 5 wird der Transponder-Chip 15 mit den beiden darunter liegenden Antennen 2 und 3 fest verbunden. Das Herstellen der Transponderantennen mit dem Transponderchip 15 erfolgt bei der Herstellung des Vormaterials für die Reifenherstellung. Das vorkonfektionierte Reifenbauteil wird anschließend beispielsweise mit Reifenbautrommeln auf eine Reifenrohling aufgebracht. Das Aufbringen der Reifenbauteile erfolgt in der Weise, dass der Transponder zwischen einzelnen Reifenbauteilen angeordnet werden kann. Eine mögliche Platzierung des Transponders im Reifenwulst zeigt die Fig. 1. Mit dem Herstellungsverfahren nach Anspruch 1 lassen sich unterschiedliche Antennenformen auf dem Reifenbauteil generieren. In der Figur ist eine mäanderförmige bzw. eckige Struktur gezeigt. Die Antenne kann ebenfalls in Form von Schlangenlinien oder in Form von Dreiecken oder zickzack-förmig ausgeführt sein.

### Bezugszeichenliste

(ist Teil der Beschreibung)
- 1: Transponder
- 2: linke Antenne
- 3: rechte Antenne
- 4: Reifenkern
- 5: Kernreiter bzw. Apex
- 6: Karkasslage
- 7: Seitenwand
- 8: Reifenwulst
- 9: Gummilage
- 10: RFID-Transponder
- 11: Ion
- 12: Targetmaterial (Festkörper)
- 13: Substrat-Materiallage aus Elastomer (z.B. Reifenbauteil)
- 14: Dünnschicht bzw. Dünnschichtmaterial
- 15: Transponder-Chip
- 16: Festkörpermaterial in Form von Atomen
- 17: Äußere Lagenumschlag der Karkasslage
- 18: Höhe zwischen Transponder und Unterseite des Kernreiters
- 19: Höhe zwischen Transponder und Spitze des Kernreiters

## Patentansprüche

1. Verfahren zur Herstellung eines Transponders (1) für einen Fahrzeugreifen mit folgenden Schritten:
a) Bereitstellen eines Targetmaterials (12) aus einem Festkörper
b) Beschuss des Targetmaterials mit energiereichen Ionen (11), wobei Festkörpermaterial in Form von Atomen aus dem Targetmaterial (12) herausgelöst wird und in eine Gasphase übergeht,
c) Ablagern des Festkörpermaterials auf einer Substrat-Materiallage (13) aus einem Elastomer,
wobei die Substrat-Materiallage (13) mit einer Dünnschicht (14) aus Festkörpermaterial beschichtet wird,
wobei die die Substrat-Materiallage (13) ein Reifenbauteil ist,
d) Abtragen von Teilbereichen der Dünnschicht (14) von der Substrat-Materiallage (13) mit einem Abtragungsverfahren
e) Erzeugen einer Antenne (2,3) für einen Transponder (1) auf der Substrat-Materiallage (13),
wobei die Antennenform der Antenne (2,3) mit der verbleibenden Dünschicht auf der Substrat-Materiallage (13) gebildet wird.

2. Verfahren nach Anspruch 1
**dadurch gekennzeichnet, dass**
nach Schritt e) ein Transponder-Chip (15) auf der Antenne (2,3) platziert wird, wobei durch eine direkte Kontaktierung zwischen beiden Bauteilen ein Transponder (1) mit einer angebundenen Antenne (2,3) gebildet wird.

3. Verfahren nach einem der vorhergehenden Ansprüche
**dadurch gekennzeichnet, dass**
die Schritte a) bis d) in den Herstellungsprozeß zur Herstellung des Reifenbauteiles (13) in Form von Vormaterial integriert sind.

4. Verfahren nach einem der vorhergehenden Ansprüche
**dadurch gekennzeichnet, dass**
bei Schritt d) das Abtragen von Dünnschichtmaterial (14) mit einem gerichteten Ionenstrahl oder einen hart fokussierten Laserstrahl erfolgt.

5. Verfahren nach einem der vorhergehenden Ansprüche
**dadurch gekennzeichnet, dass**
bei Schritt d) das Abtragen von Dünnschichtmaterial (14) mit einer Ätztechnik erfolgt, wobei Fotolack auf die Dünnschicht aufgebracht und anschließend strukturiert beleuchtet wird, sodass die nicht beleuchtete Dünnschicht mit einer Ätzlösung abgetragen werden kann.

6. Verfahren nach einem der vorhergehenden Ansprüche
**dadurch gekennzeichnet, dass**
bei Schritt d) eine Lift-Off-Technik eingesetzt wird, wobei Fotolack zunächst auf die Substrat-Materiallage (13) aufgebracht und strukturiert wird, sodass das anschließend aufgebrachte Dünnschichtmaterial in einem chemischen Verfahren an den Stellen abgetragen werden kann, an denen noch Fotolack vorliegt.

7. Verfahren nach einem der vorhergehenden Ansprüche
**dadurch gekennzeichnet, dass**
bei Schritt c) eine Dünnschicht (14) mit einer Materialdicke von kleiner 1 mm erzeugt wird.

8. Verfahren nach einem der vorhergehenden Ansprüche
**dadurch gekennzeichnet, dass**
bei Schritt a) der Festkörper ein Metall ist.

## Claims

1. Method for producing a transponder (1) for a vehicle tyre, having the following steps:
a) providing a target material (12) composed of a solid,
b) bombarding the target material with high-energy ions (11), wherein solid material is released from the target material (12) in the form of atoms and changes into a gaseous phase,
c) depositing the solid material on a substrate material ply (13) composed of an elastomer, wherein the substrate material ply (13) is coated with a thin film (14) composed of solid material, wherein the substrate material ply (13) is a tyre component,
d) removing partial regions of the thin film (14) from the substrate material ply (13) by means of a removal process,
e) generating an antenna (2, 3) for a transponder (1) on the substrate material ply (13),
wherein the antenna shape of the antenna (2, 3) is formed with the remaining thin film on the substrate material ply (13).

2. Method according to Claim 1,
**characterized in that**,
after step e), a transponder chip (15) is placed on the antenna (2, 3),
wherein, by means of direct contacting between the two components, a transponder (1) with an attached antenna (2, 3) is formed.

3. Method according to either of the preceding claims,
**characterized in that**
the steps a) to d) are integrated into the production process for producing the tyre component (13) in the form of a semifinished product.

4. Method according to any of the preceding claims,
**characterized in that**,
in step d), the removal of thin-film material (14) is performed using a directed ion beam or a sharply focused laser beam.

5. Method according to any of the preceding claims,
**characterized in that**,
in step d), the removal of thin-film material (14) is performed using etching technology, wherein photoresist is applied to the thin film and is subsequently illuminated in structured fashion such that the non-illuminated thin film can be removed using an etching solution.

6. Method according to any of the preceding claims,
**characterized in that**,
in step d), a lift-off technique is used, wherein photoresist is firstly applied to the substrate material ply (13) and structured such that the subsequently applied thin-film material can be removed in a chemical process at the locations at which photoresist is still present.

7. Method according to any of the preceding claims,
**characterized in that**,
in step c), a thin film (14) with a material thickness of less than 1 mm is generated.

8. Method according to any of the preceding claims,
**characterized in that**,
in step a), the solid is a metal.

## Revendications

1. Procédé de fabrication d'un transpondeur (1) destiné à un pneumatique de véhicule, le procédé comprenant les étapes suivantes :
a) fournir un matériau cible (12) formé d'une matière solide
b) bombarder le matériau cible avec des ions fortement énergétiques (11), du matériau solide étant détaché du matériau cible (12) sous forme d'atomes et se transformant en une phase gazeuse,
c) déposer le matériau solide sur une couche de matériau de substrat (13) en élastomère,
la couche de matériau de substrat (13) étant recouverte d'une couche mince (14) en matériau solide,
la couche de matériau de substrat (13) étant un composant de pneumatique,
d) abraser des zones partielles de la couche mince (14) de la couche de matériau de substrat (13) à l'aide d'un procédé d'ablation
e) générer une antenne (2, 3) destinée à un transpondeur (1) sur la couche de matériau de substrat (13),
la forme de l'antenne (2, 3) étant réalisée avec la couche mince restante sur la couche de matériau de substrat (13).

2. Procédé selon la revendication 1,
**caractérisé en ce que**
après l'étape e) une puce de transpondeur (15) est placée sur l'antenne (2, 3),
un transpondeur (1) relié à une antenne (2, 3) étant formé par contact direct entre les deux composants.

3. Procédé selon l'une des revendications précédentes,
**caractérisé en ce que**
les étapes a) à d) sont intégrées dans le processus de fabrication pour fabriquer le composant de pneumatique (13) sous forme de matériau primaire.

4. Procédé selon l'une des revendications précédentes,
**caractérisé en ce que**
à l'étape d) l'abrasion du matériau en couche mince (14) est effectuée avec un faisceau ionique dirigé ou un faisceau laser fortement focalisé.

5. Procédé selon l'une des revendications précédentes,
**caractérisé en ce que**
à l'étape d) l'abrasion du matériau en couche mince (14) est effectuée à l'aide d'une technique de gravure, la résine photosensible étant appliquée sur la couche mince puis éclairée de manière structurée de sorte que la couche mince non éclairée puisse être abrasée à l'aide d'une solution de gravure.

6. Procédé selon l'une des revendications précédentes,
**caractérisé en ce que**
à l'étape d) une technique de décollage est utilisée, la résine photosensible étant d'abord appliquée sur la couche de matériau de substrat (13) et structurée de sorte que le matériau en couche mince appliqué par la suite puisse être abrasé par un processus chimique aux endroits où la résine photosensible est encore présente.

7. Procédé selon l'une des revendications précédentes,
**caractérisé en ce que**
à l'étape c) une couche mince (14) est produite avec une épaisseur de matériau inférieure à 1 mm.

8. Procédé selon l'une des revendications précédentes,
**caractérisé en ce que**
à l'étape a) la matière solide est un métal.
